# EUROPEAN PATENT SPECIFICATION

(11) **EP 0 586 483 B1**
(45) Date of publication and mention of the grant of the patent: **04.11.1998**
(21) Application number: 92911355.3
(22) Date of filing: 05.06.1992
(51) Int. Cl.: G03F 7/30

(54) **METHOD AND APPARATUS FOR WASHING-OUT PRINTING PLATES**
VERFAHREN UND GERÄT ZUM AUSWASCHEN VON DRUCKPLATTEN
PROCEDE ET APPAREIL DE NETTOYAGE POUR PLAQUES D'IMPRESSION

(30) Priority: 07.06.1991 GB 91122952; 30.01.1992 GB 92020130
(43) Date of publication of application: 16.03.1994
(73) Proprietor: DANTEX GRAPHICS LTD., Bradford BD2 1EY (GB)
(72) Inventor: DANON, Richard 2 Wigton Chase, Leeds LS17 8SG (GB)
(74) Representative: Coleiro, Raymond
(86) International application number: GB9201020
(87) International publication number: WO9222015

(56) References cited:
- EP-A- 0 075 028
- DE-A- 2 734 688
- DE-A- 3 143 106
- DE-A- 3 503 974
- PATENT ABSTRACTS OF JAPAN vol. 11, no. 100 (P-561)(2547) 28 March 1987 & JP-A-61 249 058
- PATENT ABSTRACTS OF JAPAN vol. 12, no. 16 (P-656)(2363) 19 January 1988 & JP-A-62 173 473

## Description

### Field of the Invention

This invention relates to a method and apparatus for processing a pre-exposed water-washable printing plate such as a photopolymer relief printing or moulding plate or a presensitised aluminium plate and subsequently subjecting it to post and detack exposure.

### Background to the Invention

Photopolymer relief printing and moulding plates, and presensitised aluminium plates, are now extensively used in the printing industry. The production of a printing plate is generally carried out in the following manner: imagewise irradiation (main exposure), followed by removal of unhardened areas (washout), drying of the washed plate and post irradiation (post exposure). The removal of unhardened areas (washout) is generally carried out by brushing the plate in a heated fluid such as water and/or a chemical solvent such as alcohol, butyl alcohol, etc.

Printing plates fall into two categories - those that are water washable and those that need to be washed using some other chemical solvent. Recently, water washable type photopolymer plates have gained considerable market presence, largely replacing the organic solvent washable type. The most important reason for the popularity of water washable plates is their environmentally friendly nature and working conditions, especially compared to those of organic solvent washable plates.

Methods for washing out such plates, either of the water or of the organic solvent washable type, are known. These are generally carried out in either automatic in-line or stacker type processors, and usually involve the recirculation of a fixed volume of washout fluid, through a washout chamber, a number of times before the fluid is discarded.

For instance, an existing processor might typically operate with a fixed volume of washout fluid, contained and heated in a holding tank within the processor. This fluid is pumped, in the case of an in-line automatic processor, to the washout chamber of the processor, where it is brought into contact with a washout brush and a plate to be washed. Having been in contact with the printing plate, the fluid then returns - usually via gravity - to the holding tank ready to be re-pumped back to the washout chamber in a closed loop. In the case of a stacker type processor, the plate being washed, along with the washout brush, is immersed directly into the holding tank.

There are several problems associated with the use of such washing-out methods, as follows:-
1. As subsequent plates are processed, the quality of the washout fluid in the holding tank deteriorates. Its viscosity increases and its washout efficiency is reduced, because the level of waste material within the fluid and holding tank increases with each plate processed.
2. The efficiency of the methods, with regard to energy consumption and practical operation of the processors used, is low due to the fact that a) there is a considerable delay in initial start-up of the processor, in order for the fixed volume of washout fluid to be heated to its optimum operating temperature; and b) a high proportion of energy is wasted in the continuous re-heating of fluid in the holding tank in order to maintain the operating temperature (i.e. to combat natural heat loss) whilst the processor is in 'stand-by' mode. Stand-by mode is typically utilised for as much as 75% of a working day or shift when processing a plurality of plates in a normal daily production cycle.
3. At the end of a processing cycle or working day, the user is presented with a high volume of waste washout fluid which contains a high concentration of photopolymer waste. Should this volume of fluid require filtration (as is normally the case) and/or subsequent processing for re-use of the fluid, the user must have available a filtration system that can physically handle the large fluid volume and high waste concentration involved. Such filtration systems are generally expensive, physically large, inconvenient and require large amounts of additional energy and operator attention.
4. Current washout systems usually have an upturned washout brush (bristles uppermost) which tends to suffer from 'brush clogging'. This happens because there is insufficient washout fluid circulation within the area of the brush and also because the printing plate being processed is above the brush, so that gravity causes the washed out particles/residue of plate material to fall into and collect within the bristles of the brush and reduce its effectiveness. In order to overcome this common problem, it is usually necessary to continue washing the plate for extended periods to achieve the required amount of relief. However, this can often lead to unacceptable swelling of the plate if it absorbs too much washout fluid into its exposure hardened areas, because of its extended contact time with the fluid.

Documents describing systems for washing out printing plates are EP-A-0075028, which discloses the development of a spray of washout liquid and a heat exchanger to heat the liquid, DE-A-3143100 and JP-A-62173473 each of which discloses application of a spray and filtration and recycling arrangements for the washout liquid, DE-A-2734688 which discloses bristles with spray jets between the bristles and the use of fresh clean fluid as a self-cleaning system and JP-A-61-249058 which discloses rotating downwardly directed bristles with spray jets and a heater to heat the liquid. Some of these systems provide a solution to at least one of the abovementioned problems.

EP-A-0017927 describes a method processing a printing plate in which, after initial exposure, the plate is further subjected to post exposure, then dried and thereafter subjected to detack exposure.

The present invention seeks to provide a method and apparatus for washing out a printing plate, which not only, at least in embodiments thereof, overcome or at least mitigate the above described problems, but enable a final drying process to be carried out subsequently to post and detack exposure as later described. An effective and economical washing out procedure is sought which will also respect the need for energy conservation and environmental issues.

### Statement of the invention

According to the present invention there is provided a method for processing a pre-exposed water-washable printing plate, which method comprises the steps of
(i) providing a source of clean and/or filtered washout water,
(ii) directing the said washout water continuously downwardly through a spray bar along downwardly directed bristles of a washout brush,
(iii)brushing the plate with the washout brush,
(iv) allowing the washout water to flow continuously to waste, or to a cleaning and/or filtering station after its contact with the plate,
(v) subjecting the plate to each of post and detack exposure and,
(vi) subsequent to step (v), subjecting the plate to a drying step.

The method may be carried out after assessing the minimum steady, continuous washout water flow rate necessary to achieve an optimum washout of unexposed material from the pre-exposed water-washable printing plate, the washout water then being directed downwardly through a spray bar at the said steady, minimum flow rate and along downwardly directed bristles of a washout brush, so that during brushing of the plate with the washout brush, the plate is subjected to a steady, continuous flow of washout water at the said minimum flow rate.

Thus, in the above method , the washout fluid is not recirculated unless and until it has been cleaned and can be used in a fresh, clean form. The plate is thus continuously treated using clean washout water. The water is also supplied to the plate in a continuous flow, rather than as a fixed volume which is used and re-used in a closed-loop system until it has become unacceptably dirty and needs to be discarded.

The plate which can be washed out using the method of the invention may be a photopolymer relief printing or moulding plate, a presentitised aluminium printing plate, or any other type of plate which needs to be washed out post-exposure to remove unexposed areas.

The flow of washout water to which the plate is subjected is at a steady, relatively slow rate. The water is directed to flow onto the plate through a spray bar which may be of conventional construction, such as to ensure an even distribution of the water over the plate. The spray bar may form part of a washout brush used to brush the plate during the washing-out process, the water thus being sprayed onto the plate through the brush used to clean it.

The washout brush has downwardly-directed bristles during use, such that the brush contacts the printing plate from above. Such a brush suffers very little brush clogging compared to conventionally-used brushes which have upwardly-directed bristles during use.

The washout water allowed to flow to waste may subsequently be discarded. Alternatively, it may be filtered and/or otherwise cleaned ready for re-use. Such filtered water can then be re-directed into the flow of fresh, clean water over the printing plate, for example by means of a closed-loop system in which cleaned water is recycled to maintain economy and efficiency.

The washout water to which the plate is subjected is preferably heated to a desired operating temperature before it is allowed to flow over the plate. This is conveniently achieved by means of an instantaneous water heater positioned in the flow of the water, upstream of the printing plate. The temperature of the water flow to which the plate is subjected can thus be controlled to be at the correct operating temperature prior to the washout procedure.

The present invention additionally provides apparatus for processing a pre-exposed printing plate, comprising
(i) a source of clean and/or filtered water;
(ii) mean for providing a continuous washout water flow;
(iii) a spray bar adapted to receive the washout water and having a brush depending therefrom, which brush has downwardly directing bristles, whereby the washout water is capable of flowing continuously from the spray bar and down the bristles on to the printing plate;
(iv) means for continuously removing the waste washout water from the plate and allowing the washout water to flow continuously to waste, or to a cleaning and/or filtering station after its contact with the plate;
(v) means for effecting each of post exposure and detack exposure; and
(vi) downstream of the means for effecting each of the post exposure and detack exposure means, a dryer for drying the exposed plate.

The apparatus preferably additionally comprises one or more of the following:-
1. a plate holder (typically of conventional construction) for holding one or more plates in position in the apparatus;
2. an instantaneous water- heater, upstream of the plate, for heating washout water from the source prior to its supply to the plate; and
3. a washout chamber in which the plate may be positioned.

The plate holder may be either a fixed position, a linear-tracking, a multi-directional or any other suitable type of plate holder which is available. The washout brush may be capable of an omni-directional, bi-directional, multi-directional, orbital or linear brushing action, or may be fixed, depending on the type of plate holder in association with which it is to be used.

The means for supplying washout water to the plate preferably comprises a spraybar, which conveniently forms part of a washout brush. The means for removing the water for filtration preferably comprises a catchment tray (conveniently positioned below a plate holder) for collecting the water and directing it towards an outlet, either to filter and thence to waste or to be filtered and/or cleaned.

The apparatus may additionally comprise filtration means for filtering and/or cleaning removed washout water. The apparatus may then also comprise means for recirculating the washout water , after it has been filtered by the filtration means, back to the washout water source ready for re-use. This forms a closed-loop system for the washout water.

The invention is most appropriately designed with the aid of the catchment tray to allow for a steady flow of removed washout water to be introduced into the filtration system.

This additional filtration system for filtering and cleaning the washout water has the option to return the cleaned water back to the washout brush head or to introduce the clean water to main drain.

The apparatus may be adapted for either automatically or manually controlled operation.

The processing apparatus may be of either the "in-line" or the "stacker" type, both well known and commonly available types of plate processor.

The present invention will now be described, by way of example only, with reference to the accompanying illustrative drawings, of which:-
- Figure 1 shows schematically apparatus for washing out printing plates, forming part of apparatus in accordance with the invention;
- Figures 2-5 show alternative types of brush and plate holder for use in the apparatus shown in Figure 1;
- Figure 6 shows schematically an automatic in-line printing plate processor incorporating the apparatus shown in Figure 1; and
- Figure 7 shows schematically a stacker type printing plate processor incorporating the apparatus shown in Figure 1.

### Detailed Description of the Drawings

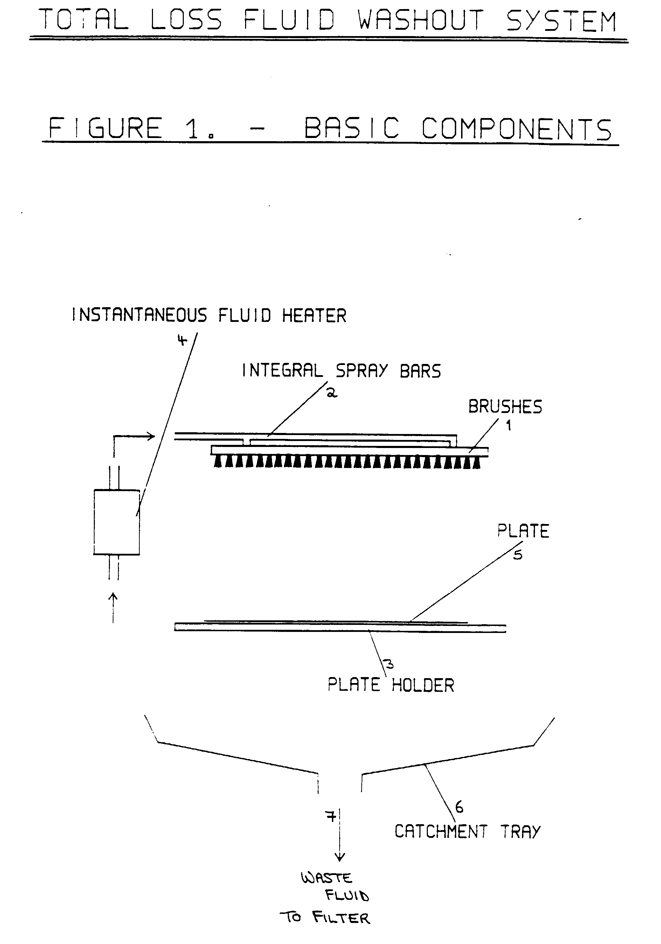

Apparatus for washing out a pre-exposed printing plate and forming part of processing apparatus in accordance with the invention is shown schematically in Figure 1. It comprises:
- A down-turned brush pad 1 (bristles lowermost), with integral spray bars 2 for even distribution of washout water. This brush pad may have a fixed position-or an omni-directional or bi-directional orbital action when used in conjunction with the moving plate holder 3 which may be flat or of the-drum type.
- An instantaneous heating device 4 situated within a main washout fluid supply circuit, complete with its own electronic temperature monitoring and control apparatus.
- A plate holding device 3, which may be flat or cylindrical and can be in a fixed position or have multi-directional motion. The purpose of the plate holder 3 is to physically hold the printing plate 5 so that the surface to be washed out is held in, or brought into, contact with the washout brush 1.
- A catchment tray 6 which is located under and in close proximity to the plate holding device 3. Its function is to collect waste washout water (as it falls through gravity) and channel it towards a point of exit (7) or to an internal or externally mounted filtration unit and/or fluid recycling system.
- Electronic/electromechanical sequential control (not shown) which has the function of timing the operation of the instantaneous water heating device 4 along with water flow to the brush head 1. This control system is useful in achieving a system of 'plate wetting' which is the automatic application of water to the plate surface, prior to contact with the washout bristles (sometimes necessary to protect the print surface of photopolymer relief printing or moulding plates).

In use, fresh, clean washout water is fed continuously from a source (not shown) to the spray bars 2 via heater 4. It is then, after its contact with plate 5, allowed to flow continuously into catchment tray 6, from which it flows either to waste, to filtration ready for re-use or to filtration and then to drain. There is no holding tank for the water, and it is not recirculated in a closed loop directly from tray 6 back to heater 4 and thence to spray bars 2. Closed-loop recirculation is introduced only after filtration and/or cleaning of the waste washout water.

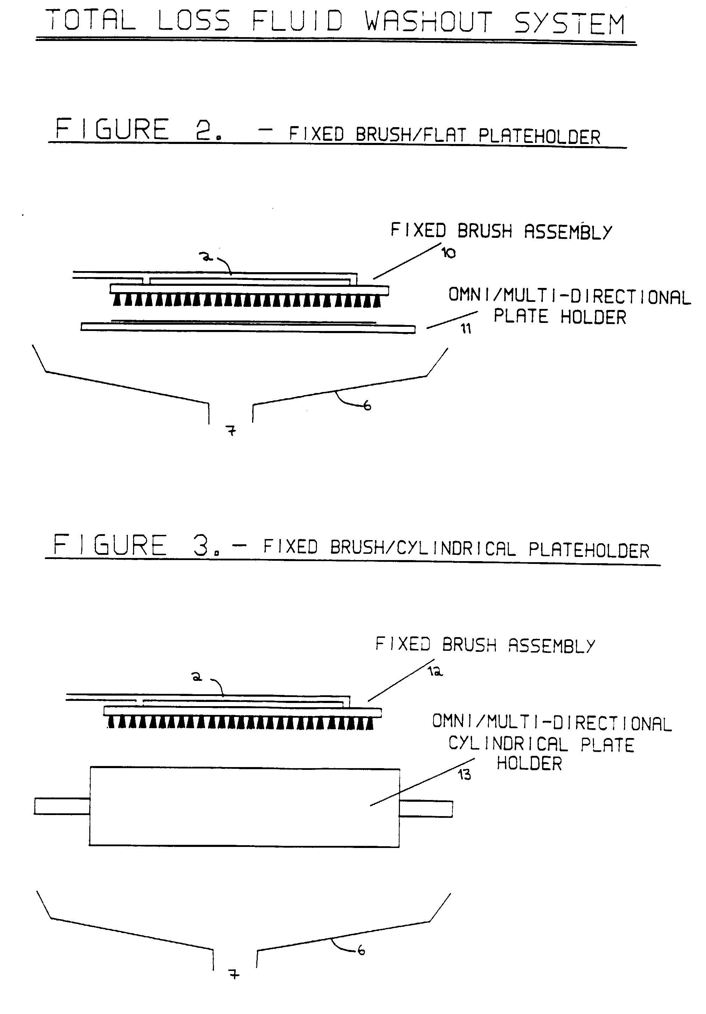

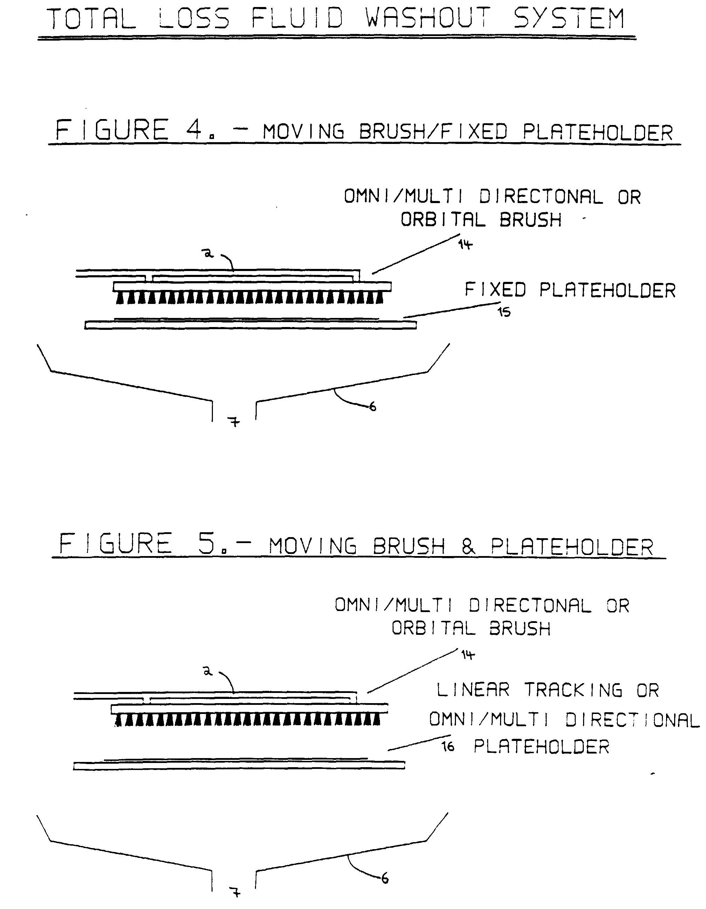

Figures 2-5 show how different types of brush pad may be used with different types of plate holder in the apparatus shown in Figure 1. In Figure 2, a fixed brush assembly 10 is shown for use with an omni- or multi-directional moving plate holder 11. In Figure 3, fixed brush assembly 12 is used with an omni- or multi-directional moving cylindrical plate holder 13. Figure 4 shows the use of an omni- or multi-directional, or an orbital, moving brush 14 with a fixed plate holder 15. Figure 5 shows the same brush 14, this time for use with a linear tracking or omni- or multi-directional moving plate holder 16 (i.e. both brush and plate holder moving).

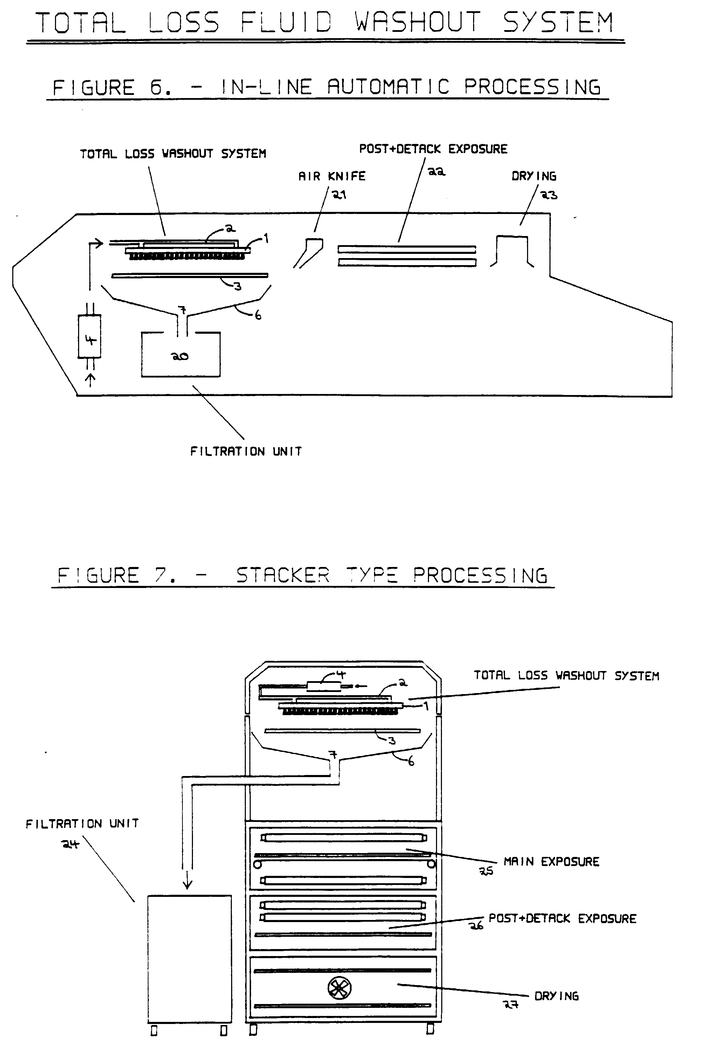

Figures 6 and 7 show how the apparatus of Figure 1 may be incorporated into printing plate processors, either of the "in-line" type (Figure 6) or of the "stacker" type (Figure 7).

In the processor shown in Figure 6, washout water collecting in the catchment tray 6 of the washout apparatus passes to the filtration unit 20, where it is filtered and/or cleaned ready to be re-introduced into the washout brush head, thus achieving an economical and highly efficient closed-loop system. Alternatively the washout water , after filtration and/or cleaning, may be introduced to main drain.

Washed out plates pass through the processor to air knife 21, post and detack exposure section 22 and drying section 23, all conventional components in a printing plate processor. It is to be noted that, in contrast to the apparatus for carrying out the method of EP-A-0017927, drying section 23 is disposed downstream of post and detack exposure section 22.

In the multi-cabinet or 'stacker' type processor shown in Figure 7, plates are manually introduced to the different treatments forming part of a plate making procedure. The production of the plates is carried out in main exposure (25), washing out (top of the processor), post and detack exposure (26) and drying (27) sections of the processor.

The washout water from the catchment tray (6) is again passed to a filtration unit (24) for filtering and either re-circulation or passage to main drain.

In both processors, the filtration unit could either be a component of the processor or a free-standing unit connected to the processor.

The advantages of the method and apparatus of the invention, and particularly of the apparatus shown in Figure 1, are as follows:
a. Efficient washout of non-irradiated areas of the printing plate is achieved by a downward facing brush which does not suffer from 'brush clogging', coupled with a continuous supply of clean washout water evenly distributed over the area of the washout brush via the integral spray bars.
b. Washout time is thus reduced by up to 50% when compared to present washout systems.
c. The risk of subsequent plate swell is also greatly reduced, if not totally irradicated.
d. Simplicity of construction is evident when compared to conventional washout systems, as the requirement for heater pumps and fluid level control devices (in the holding tank) no longer exists.
e. An additional benefit is the lower level of day to day and routine engineering maintenance required.
f. The apparatus is more suitable for inclusion within modern printing plate processing equipment used for photopolymer and presensitised aluminium plates, due to the reduction in physical space required to accommodate its component parts. This is again achieved by the removal of any requirement for recirculation pumps, water holding tanks and associated control equipment.
g. A high degree of energy conservation is achieved, since energy is only utilised when the invention is actually in operation calling for heated water and the setting up of the sequential actions of further processing of printing plates.
h. The production of environmentally friendly water washable photopolymer relief printing and moulding plates is further enhanced since the system of the invention releases a controlled low volume flow of waste washout water , having a relatively low concentration of waste photopolymer. This allows the use of an automatic, convenient to use, compact and energy efficient filtration system.
i. A substantial reduction in the level of water consumption is achieved - up to 50% less than in conventional in-line systems - as the invention uses only as much water as it requires to achieve optimum washout which in turn is determined via the control board setting.
j. Pre-heated washout water is introduced into the washout chamber for only as long as it is necessary to wash out a plate. As there is no fluid holding tank, energy requirements are greatly reduced.
k. The apparatus of the invention is particularly efficient in that the filtration system filters and/or cleans only the pre-calculated amount of water which is needed to achieve the washout of a printing plate.

## Claims

1. A method for processing a pre-exposed water-washable printing plate, which method comprises the steps of
(i) providing a source of clean and/or filtered washout water,
(ii) directing the said washout water continuously downwardly through a spray bar along downwardly directed bristles of a washout brush,
(iii) brushing the plate with the washout brush,
(iv) allowing the washout water to flow continuously to waste, or to a cleaning and/or filtering station after its contact with the plate,
(v) subjecting the plate to each of post and detack exposure and,
(vi) subsequent to step (v), subjecting the plate to a drying step.

2. A method according to claim 1, wherein the washout water allowed to flow to waste is subsequently filtered and/or otherwise cleaned ready to be re-directed into the flow of fresh, clean water over the printing plate.

3. A method according to claim 1 or 2, wherein the washout water to which the plate is subjected is heated to a desired operating temperature before it is allowed to flow over the plate, by means of a heater capable of instantaneously heating the water and positioned in the flow of the water, upstream of the printing plate.

4. Apparatus for processing a pre-exposed printing plate, comprising
(i) a source of clean and/or filtered water;
(ii) means for providing a continuous washout water flow;
(iii) a spray bar adapted to receive the washout water and having a brush depending therefrom, which brush has downwardly directing bristles, whereby the washout water is capable of flowing continuously from the spray bar and down the bristles onto the printing plate;
(iv) means for continuously removing the waste without water from the plate and allowing the washout water to flow continuously to waste, or to a cleaning and/or filtering station after its contact with the plate;
(v) means for effecting each of post exposure ana detack exposure; and
(vi) downstream of the means for effecting each of the post exposure and detack exposure means, a dryer for drying the exposed plate.

5. Apparatus according to claim 4, additionally comprising a plate holder for holding one or more plates in position in the apparatus.

6. Apparatus according to claim 4 or 5, additionally comprising a heater, upstream of the plate, for heating instantaneously the washout water from the source prior to its supply to the plate.

7. Apparatus according to any one of claims 4 to 6, additionally comprising filtration means for filtering and/or cleaning removed washout water.

8. Apparatus according to claim 7, additionally comprising means for recirculating the washout water, after it has been filtered by the filtration means, back to the washout water source ready for re-use.

## Patentansprüche

1. Verfahren zur Bearbeitung einer vorbelichteten, mit Wasser waschbaren Druckplatte, welches Verfahren die folgenden Schritte umfaßt:
(i) Bereitstellen einer Quelle sauberen und/oder filtrierten Auswaschwassers,
(ii) Kontinuierliches Richten des Auswaschwassers nach unten durch einen Spritzstab entlang nach unten gerichteter Borsten einer Auswaschbürste,
(iii) Bürsten der Platte mit der Auswaschbürste,
(iv) Kontinuierliches Abfließenlassen des Auswaschwassers nach seinem Kontakt mit der Platte zum Abfluß oder zu einer Reinigungs- und/oder Filterstation,
(v) Unterziehen der Platte jeweils einer Nachbelichtung und Klebfreimachbelichtung und
(vi) Unterziehen der Platte einem Trocknungsschritt nach Schritt (v).

2. Verfahren nach Anspruch 1, worin das Auswaschwasser, das zum Abfluß fließen gelassen wird, danach filtriert und/oder auf andere Weise gereinigt wird, sodaß es erneut dem Strom an frischem, sauberem Wasser über die Druckplatte zugeführt werden kann.

3. Verfahren nach Anspruch 1 oder 2, worin das Auswaschwasser, dem die Platte ausgesetzt wird, auf eine gewünschte Betriebstemperatur erhitzt wird, bevor es über die Platte fließen gelassen wird, wobei das Erhitzen mittels eines Heizgeräts erfolgt, das das Wasser sofort erhitzen kann und im Wasserstrom stromauf von der Druckplatte positioniert ist.

4. Vorrichtung zur Bearbeitung einer vorbelichteten Druckplatte, umfassend
(i) eine Quelle sauberen und/oder filtrierten Wassers;
(ii) Mittel, die für einen kontinuierlichen Auswaschwasserstrom sorgen;
(iii) einen Spritzstab, der ausgebildet ist, das Auswaschwasser aufzunehmen, und eine davon herabhängende Bürste aufweist, die nach unten gerichtete Borsten besitzt, wodurch das Auswaschwasser kontinuierlich vom Spritzstab die Borsten hinunter auf die Druckplatte herabfließen kann;
(iv) Mittel zum kontinuierlichen Entfernen der Abfallstoffe ohne Wasser von der Platte und Ermöglichen des kontinuierlichen Strömens des Auswaschwassers zum Abfluß oder zu einer Reinigungs- und/oder Filterstation nach dessen Kontakt mit der Platte;
(v) Mittel zur jeweiligen Durchführung von Nachbelichtung und Klebfreimachbelichtung; und
(vi) stromab von den Mitteln zur jeweiligen Durchführung von Nachbelichtung und Klebfreimachbelichtung: einen Trockner zum Trocknen der belichteten Platte.

5. Vorrichtung nach Anspruch 4, weiters umfassend eine Plattenhalterung zum Festhalten einer oder mehrerer Platten in der Vorrichtung.

6. Vorrichtung nach Anspruch 4 oder 5, weiters umfassend ein Heizgerät stromauf von der Platte, um das Auswaschwasser aus der Quelle vor seiner Zufuhr zur Platte sofort zu erhitzen.

7. Vorrichtung nach einem der Ansprüche 4-6, weiters umfassend Filtermittel zum Filtrieren und/oder Reinigen von entferntem Auswaschwasser.

8. Vorrichtung nach Anspruch 7, weiters umfassend Mittel zum Zurückführen des Auswaschwassers zur Auswaschwasserquelle, nachdem es durch die Filtermittel filtriert wurde, sodaß es zur Wiederverwendung bereitsteht.

## Revendications

1. Méthode de traitement d'une plaque d'impression préexposée, lavable à l'eau, laquelle méthode comprend les étapes de :
(i) Prévoir une source d'eau propre et/ou filtrée de lavage,
(ii) diriger ladite eau de lavage continuellement vers le bas à travers une barre de pulvérisation le long des poils dirigés vers le bas d'une brosse de lavage
(iii)brosser la plaque avec la brosse de lavage,
(iv) permettre à l'eau de lavage de s'écouler continuellement vers le rebut ou à une station de nettoyage et/ou de filtration après son contact avec la plaque,
(v) soumettre la plaque à chacune d'une post-exposition et d'une exposition pour supprimer l'adhésivité et,
(vi) subséquemment à l'étape (v), soumettre la plaque à une étape de séchage.

2. Méthode selon la revendication 1, où l'eau de lavage qui peut s'écouler vers le rebut est subséquemment filtrée et/ou autrement nettoyée, prête pour être redirigée dans l'écoulement d'eau propre et fraîche sur la plaque d'impression.

3. Méthode selon la revendication 1 ou 2, où l'eau de lavage à laquelle la plaque est soumise est chauffée à une température souhaitée de fonctionnement avant de la laisser s'écouler sur la plaque, au moyen d'un réchauffeur capable de chauffer instantanément l'eau et qui est placé dans l'écoulement de l'eau, en amont de la plaque d'impression.

4. Appareil pour le traitement d'une plaque d'impression préexposée, comprenant
(i) une source d'eau propre et/ou filtrée ;
(ii) un moyen pour produire un écoulement continu d'eau de lavage ;
(iii) une barre de pulvérisation adaptée à recevoir l'eau de lavage et ayant une brosse qui en pend, laquelle brosse a des poils dirigés vers le bas, ainsi l'eau de lavage peut s'écouler continuellement de la barre de pulvérisation et vers le bas, le long des poils sur la plaque d'impression ;
(iv) un moyen pour retirer continuellement l'eau de lavage de la plaque et permettre à l'eau de lavage de s'écouler continuellement vers le rebut, ou vers une station de nettoyage et/ou de filtration après son contact avec la plaque ;
(v) un moyen pour effectuer chacune de la post-exposition et de l'exposition pour supprimer l'adhésivité ; et
(vi) en aval du moyen pour effectuer chacune de la post-exposition et de l'exposition pour supprimer l'adhésivité, un séchoir pour sécher la plaque exposée.

5. Appareil selon la revendication 4, comprenant additionnellement un support de plaque pour supporter une ou plusieurs plaques en position dans l'appareil.

6. Appareil selon la revendication 4 ou 5, comprenant additionnellement un réchauffeur en amont de la plaque pour chauffer instantanément l'eau de lavage de la source avant sa fourniture à la plaque.

7. Appareil selon l'une quelconque des revendications 4 à 6, comprenant additionnellement un moyen de filtration pour filtrer et/ou nettoyer l'eau enlevée de lavage.

8. Appareil selon la revendication 7, comprenant additionnellement un moyen pour la remise en circulation de l'eau de lavage après l'avoir filtrée par le moyen de filtration, et son retour à la source d'eau de lavage, prête pour une réutilisation.
